# EUROPEAN PATENT APPLICATION

(11) **EP 2 811 521 A1**
(43) Date of publication of application: **10.12.2014**
(21) Application number: 14162135.9
(22) Date of filing: 27.03.2014
(51) Int. Cl.: H01L 27/142

(54) **Solar cell and method of manufacturing the same**

(30) Priority: 03.06.2013 KR 20130063502
(71) Applicant: Samsung SDI Co., Ltd., Yongin-si, Gyeonggi-do (KR)
(72) Inventor: Kim, Young-Su, Gyeonggi-do (KR); Kim, Min-Kyu, Gyeonggi-do (KR); Kim, Su-Yeon, Gyeonggi-do (KR); Kang, Ku-Hyun, Gyeonggi-do (KR)
(74) Representative: Mounteney, Simon James

(57) **Abstract**

A solar cell including a substrate and a plurality of electrically connected unit cells on the substrate. A unit cell of the unit cells includes a first electrode, a light absorbing layer, and a second electrode, sequentially stacked. Adjacent unit cells of the unit cells are separated by an isolation region. The isolation region is between the light absorbing layers of the adjacent unit cells and between the second electrodes of the adjacent unit cells. A cross-section of the isolation region has step-shaped patterns in a direction perpendicular to the substrate, and the step-shaped patterns oppose one another. A method of manufacturing the solar cell includes sequentially stacking a first electrode, a light absorbing layer, and a second electrode on a substrate, and forming an isolation region in the light absorbing layer and the second electrode. The forming of the isolation region includes heat-forming a portion of the isolation region followed by mechanical-forming another portion of the isolation region.

## Description

### BACKGROUND

### 1. Field

The present disclosure relates to a solar cell, and more particularly, to patterning a structure for electrically connecting a plurality of unit cells. The present disclosure also relates to a method of manufacturing a solar cell including patterning the structure.

### 2. Description of the Related Art

In order to modulate a solar cell, a process of dividing an electrode and a light absorbing layer formed on a substrate into a plurality of unit cells, and connecting the unit cells in series is desired.

The electrode and the light absorbing layer should be appropriately patterned so that the unit cells are electrically connected while being physically divided. In order to prevent or reduce deterioration of a completed solar cell, it is desired to prevent or reduce damage to the electrode during patterning.

The information disclosed in this section is only intended to provide a better understanding of present disclosure and therefore may contain information that is not already known to a person of ordinary skill in the art.

### SUMMARY

Aspects of embodiments of the present invention are directed toward providing a solar cell having a patterning structure capable of minimizing or reducing damage to an electrode during manufacturing of a module of the solar cell, and in particular, during patterning of the electrode and a light absorbing layer of the solar cell.

Further, aspects of embodiments of the present invention are directed toward providing a method of manufacturing the solar cell.

In an embodiment, a solar cell is provided. The solar cell includes a substrate and a plurality of electrically connected unit cells on the substrate. A unit cell of the unit cells comprises a first electrode, a light absorbing layer, and a second electrode, sequentially stacked. Adjacent unit cells of the unit cells are separated by an isolation region. The isolation region is between the light absorbing layers of the adjacent unit cells and between the second electrodes of the adjacent unit cells. A cross-section of the isolation region has step-shaped patterns in a direction perpendicular to the substrate and the step-shaped patterns oppose one another.

In one embodiment, the isolation region has a recess structure.

In one embodiment, in the recess structure, a width of a recess of the light absorbing layer is smaller than a width of a recess of the second electrode.

In one embodiment, the width of the recess of the second electrode is 30 µm to 70 µm.

In one embodiment, the step-shaped patterns form a bisymmetric step-shaped pattern.

In one embodiment, the step-shaped patterns are opposite step-shaped patterns in the direction perpendicular to the substrate.

In one embodiment, the second electrode is conductive and transparent.

In one embodiment, the second electrode includes one selected from the group consisting of BZO, ZnO, In₂O₃, and ITO.

In one embodiment, the unit cell of the unit cells further comprises a buffer layer between the light absorbing layer and the second electrode, and the isolation region is between the buffer layers of the adjacent unit cells.

In an embodiment, a method of manufacturing a solar cell is provided. The method includes sequentially stacking a first electrode, a light absorbing layer, and a second electrode on a substrate, and forming an isolation region in the light absorbing layer and the second electrode. The forming of the isolation region includes heat-forming a portion of the isolation region followed by mechanical-forming another portion of the isolation region.

In one embodiment, the heat-forming is performed by a laser.

In one embodiment, the laser has a wavelength of 266 nm to 1,064 nm, and a pulse width of 0.001 ns to 100 ns.

In one embodiment, the mechanical-forming is performed by a needle.

In one embodiment, in the heat-forming, the second electrode is completely removed or partially removed from the light absorbing layer.

In one embodiment, in the mechanical-forming, the light absorbing layer is completely removed or partially removed from the substrate.

In one embodiment, a cross-section of the isolation region has step-shaped patterns in a direction perpendicular to the substrate and the step-shaped patterns oppose one another.

In one embodiment, a cross-section of the isolation region has step-shaped patterns in a direction perpendicular to the substrate and the step-shaped patterns form a bisymmetric step-shaped pattern.

In one embodiment, a cross-section of the isolation region has step-shaped patterns in a direction perpendicular to the substrate and the step-shaped patterns are opposite step-shaped patterns in the direction perpendicular to the substrate.

In one embodiment, the method further includes stacking a buffer layer between the light absorbing layer and the second electrode.

In one embodiment, the forming of the isolation region in the light absorbing layer and the second electrode, includes forming the isolation region in the buffer layer.

### BRIEF DESCRIPTION OF THE DRAWINGS

FIG. 1 is a cross-sectional view schematically illustrating a structure of a solar cell according to an embodiment.
FIGS. 2 to 8 are cross-sectional views schematically illustrating a method of forming a solar cell according to an embodiment.

### DETAILED DESCRIPTION

In the following detailed description, only certain embodiments of the present invention are shown and described, by way of illustration. Embodiments of the present invention are described hereinafter with reference to the accompanying drawings, in which embodiments of the invention are shown. As those skilled in the art would realize, the described embodiments may be modified in various different ways, all without departing from the spirit or scope of the present invention.

Accordingly, the drawings and description are to be regarded as illustrative in nature and not restrictive. The invention may be embodied in many different forms and should not be construed as being limited to the embodiments set forth herein. The use of "may" when describing embodiments of the present invention refers to "one or more embodiments of the present invention." Expressions such as "at least one of," when preceding a list of elements, modify the entire list of elements and do not modify the individual elements of the list. Like reference numerals designate like elements throughout the specification.

The size and thickness of each configuration in the drawings are arbitrarily shown for ease of understanding and ease of description, but the present invention is not limited thereto.

In the drawings, the thickness of layers, films, panels, regions, etc., are exaggerated for clarity. In the drawings, for understanding and ease of description, the thickness of some layers and areas is exaggerated. It will be understood that when an element such as a layer, film, region, or substrate is referred to as being "on" another element, it can be directly on the other element or indirectly on the other element with one or more intervening elements therebetween.

In addition, unless explicitly described to the contrary, the word "comprise" and variations such as"comprises" or "comprising," will be understood to imply the inclusion of stated elements but not the exclusion of other elements. Further, in the specification, when an element is "on" another element, such positioning may be above or below the the other element, and does not refer only to positioning on an upper side of the other element, in terms of a direction of gravity.

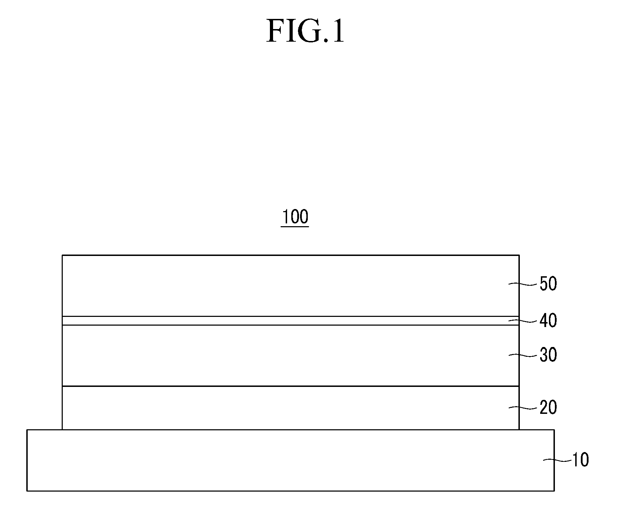

FIG. 1 is a cross-sectional view schematically illustrating a structure of a solar cell according to an embodiment.

Referring to FIG. 1, a solar cell 100 in one embodiment includes a substrate 10, a first electrode (also referred to as "a lower electrode") 20, a light absorbing layer (also referred to as "a photoelectric conversion layer") 30, a buffer layer 40, and a second electrode (also referred to as "an upper electrode") 50.

The solar cell 100 of in one embodiment is a thin film solar cell, for example, a compound semiconductor thin film solar cell including Cu, In, and Se (CIS) or Cu, In, Ga, and Se (CIGS) as the light absorbing layer 30. In one embodiment, the light absorbing layer 30 includes CIS or CIGS, but the light absorbing layer is not limited thereto. Other compounds suitable for use in a thin film solar cell may also be used as the light absorbing layer according to embodiments the present invention.

The substrate 10 may be formed of various suitable materials, such as glass, ceramic, stainless steel, a metal plate, or a polymer film.

In one embodiment, the first electrode 20 is positioned on the substrate 10. In one embodiment, the first electrode 20 is formed of a metal having suitable light reflection efficiency, and suitable adhesion to the substrate 10. For example, the first electrode 20 may include molybdenum (Mo). Molybdenum (Mo) has high electrical conductivity, forms an ohmic contact with the light absorbing layer 30, and may provide suitable stability during a high temperature heating processing for forming the light absorbing layer 30.

In one embodiment, the light absorbing layer 30 is positioned on the first electrode 20. According to an embodiment, the light absorbing layer 30 generates electrons and holes by using light energy transmitted while passing through the first electrode 50 and the buffer layer 40. The light absorbing layer 30 may include a chalcopyrite-based compound semiconductor, such as CuInSe, CuInSe₂,CuInGaSe, or CuInGaSe₂.

The light absorbing layer 30 may be manufactured by forming a precursor layer (e.g., by sputtering copper (Cu) and indium (In), or copper (Cu), indium (In), and gallium (Ga) on the first electrode 20); thermally depositing selenium (Se) on the precursor layer; and growing Cu, In, and Se (CIS) or Cu, In, Ga, and Se (CIGS) crystals by performing a rapid heat treatment at a high temperature (e.g., equal to or higher than 550 °C for one minute or longer). In these embodiments, in order to prevent or reduce evaporation of selenium (Se) during the rapid heat treatment, a portion of Se may be substituted with sulfur (S). In these embodiments, an open voltage of the solar cell 100 may be increased by increasing an energy band gap of the light absorbing layer 30.

The buffer layer 40 may be positioned on the light absorbing layer 30. In some embodiments, buffer layer 40 relieves a difference in energy band gaps between the light absorbing layer 30 and the second electrode 50. In some embodiments, the buffer layer 40 also relieves a difference in lattice constants between the light absorbing layer 30 and the second electrode 50 to allow for bonding of the light absorbing layer 30 and the second electrode 50. The buffer layer 40 may include, for example, a cadmium sulfide (CdS), a zinc sulfide (ZnS), or an indium oxide (In₂O₃). In some embodiments, the buffer layer 40 is omitted.

In one embodiment, the second electrode 50 is positioned on the buffer layer 40. The second electrode 50 may be formed of a material having transparent conductivity. For example, the second electrode 50 may be formed of a metal oxide such as a boron doped zinc oxide (BZO), a zinc oxide (ZnO), an indium oxide (In₂O₃), or an indium tin oxide (ITO) having suitable light transmittance, and the like. In one embodiment, the second electrode 50 has high electric conductivity and high light transmittance. The second electrode 50 may be provided with a rough surface (i.e., an unevenness) by a separate texturing process. In one embodiment, a reflection preventing layer may also be provided on the second electrode 50. According to some embodiments, the rough (uneven) surface together with the reflection preventing layer of the second electrode 50 decreases external light reflection, thereby improving efficiency of transmittance of sunlight to the light absorbing layer 30.

In one embodiment, the first electrode 20, the light absorbing layer 30, the buffer layer 40, and the second electrode 50 formed as described above, are divided into a plurality of unit cells on the substrate 10, and are electrically connected to provide a module of the solar cell.

Hereinafter, a method of manufacturing the solar cell according to some embodiments will be described.

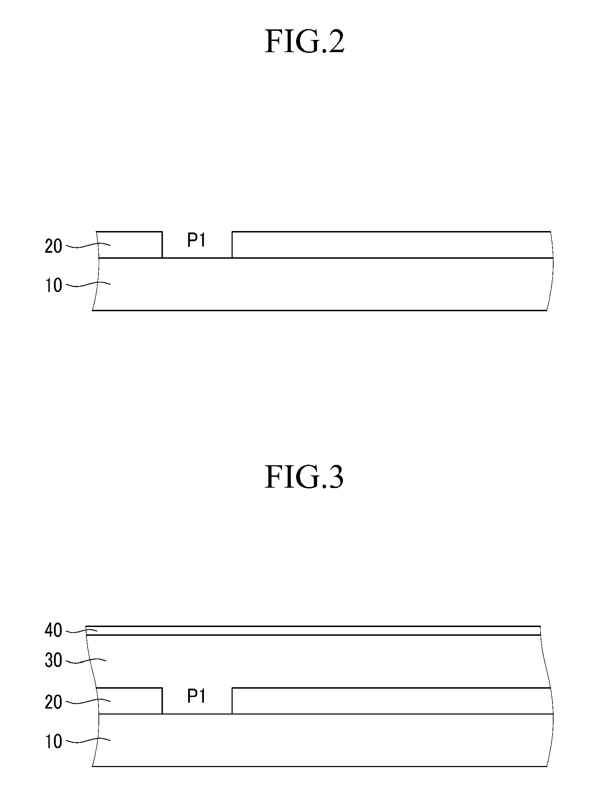

In one embodiment, , the first electrode 20 is formed on one surface of the substrate 10 with a set or predetermined thickness, for example by sputtering, and is then divided into a plurality of first electrodes. That is, in one embodiment, the first electrode 20 is patterned at a set or predetermined position by using an isolation mechanism, for example, by using a first laser (Laser 1)" and is thus divided into a plurality of first electrodes. Accordingly, in one embodiment, a first isolation region P1 is formed between the first electrodes 20 (see e.g., FIG. 2).

In one embodiment, each of the light absorbing layer 30 and the buffer layer 40 is then formed on the first electrodes 20 while maintaining a set or predetermined thickness. In one embodiment, the light absorbing layer 30 is filled in the first isolation region P1, which is a space between the first electrodes 20, as well as upper portions of the first electrodes 20 (see e.g., FIG. 3).

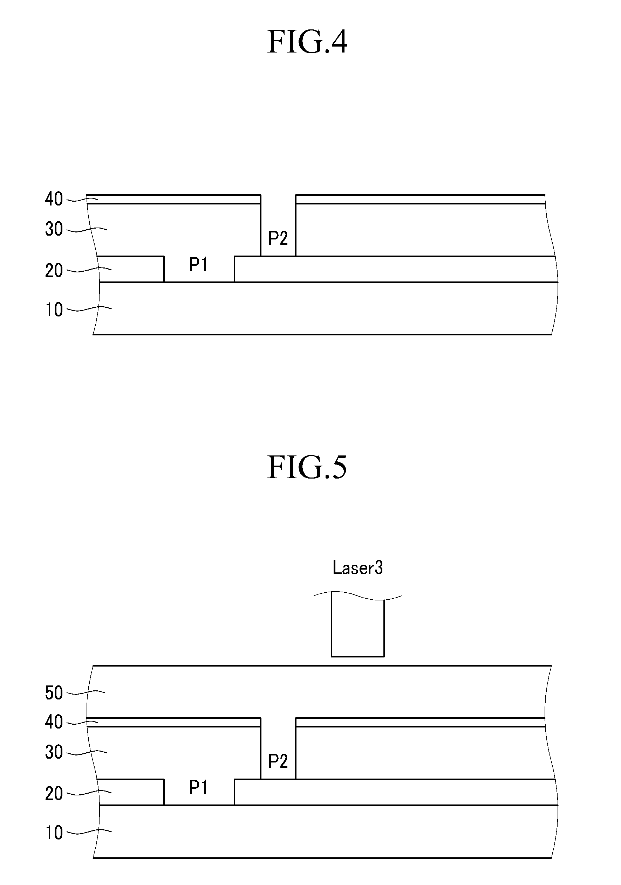

In one embodiment, a second patterning is then performed on the light absorbing layer 30 and the buffer layer 40. In one embodiment, the second patterning is performed by a laser scribing (heat) process utilizing a laser (Laser 2) and/or by a mechanical scribing process. Accordingly, the light absorbing layer 30 and the buffer layer 40 may be isolated into a plurality of light absorbing layers 30 and a plurality of buffer layers 40 by a second isolation region P2 formed at a set or predetermined portion as illustrated by way of example in FIG. 4.

In one embodiment, the second electrode 50 is then formed with a set or predetermined thickness on the buffer layer 40. In one embodiment, the forming of the second electrode 50 includes filling in the second isolation region P2, which is a recess having walls made of the light absorbing layer 30/the buffer layer 40, as well as an upper surface of the buffer layer 40 (see e.g., FIG. 5).

In one embodiment a third patterning is then performed on the light absorbing layer 30, the buffer layer 40, and the second electrode 50. In one embodiment, the third patterning is performed through multi-step process, in which the patterning is first performed on the second electrode 50 in a first step, and the patterning is performed on the buffer layer 40 and the light absorbing layer 30 in a second step.

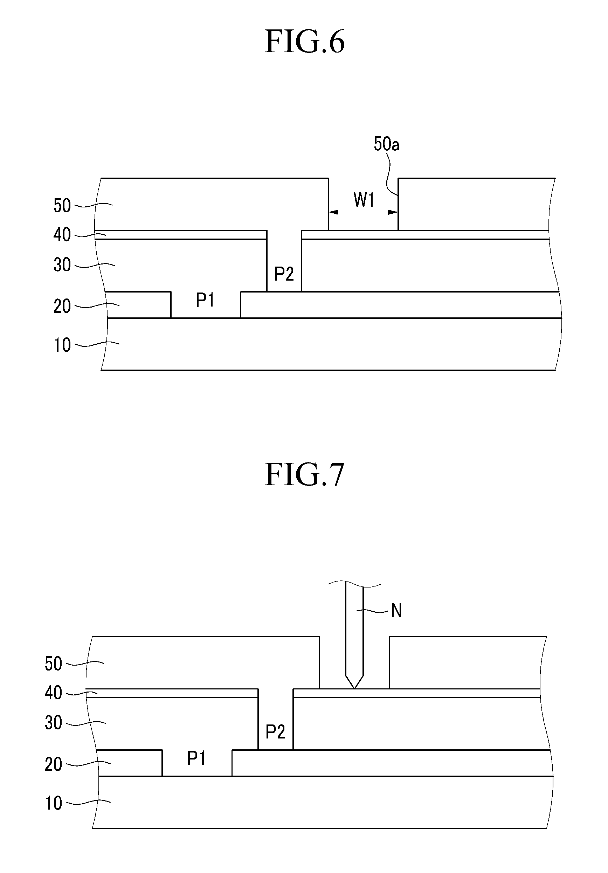

In the first step, as illustrated by way of example in FIG. 5, the second electrode 50 is scribed adjacent to the second isolation region P2 by heating (i.e., with heat energy) using a laser (Laser 3). In one embodiment, Laser 3 moves in one direction of the substrate 10 (or the substrate moves) to remove the second electrode 50 in a line pattern, so that the scribing to remove the second electrode 50 by Laser 3 is substantially complete. Accordingly, in one embodiment, a first recess 50a having a line pattern is formed in the second electrode 50, and a width W1 of the first recess 50a may be from 30 µm to 70 µm (see e.g., FIG. 6). In one embodiment, removal of the second electrode 50 by Laser 3, instead of by removal using mechanical energy, prevents or reduces damage to the second electrode 50, based on a material characteristic of the second electrode 50. For example, a laser having a wavelength of 266 nm to 1,064 nm and a pulse width of 0.001 ns to 100 ns may be used as the used Laser 3.

In one embodiment, in the first step, the first recess 50a is formed by completely or substantially removing the second electrode 50 from a portion of the light absorbing layer 30, but the first recess 50a may also be formed by removing the second electrode 50 by a suitable depth, leaving a thin layer of the second electrode 50, without completely removing the second electrode.

In one embodiment, in the second step, as illustrated in FIG. 7, the buffer layer 40 and the light absorbing layer 30 are removed by mechanical energy, for example, by using a needle N along the first recess 50a formed in the second electrode 50. The needle N is only one example of a device for providing the mechanical energy capable of removing the buffer layer 40 and the light absorbing layer 30.

In one embodiment, the needle N also forms second recesses 40a and 30a having a width W2 smaller than that of the first recess 50a in the buffer layer 40 and the light absorbing layer 30, while moving in one direction of the substrate 10 (or while the substrate moves). In one embodiment the width of W2 may be from 10 µm to 50 µm but is preferably smaller in width than W1. In these embodiments, the needle N and the laser (Laser 3) are adjacently disposed on a same line and are configured to perform the second step, which allows for an improved accuracy in alignment of the first recess 50a and the second recesses 40a and 30a. In one embodiment, in the second step, the second recesses 40a and 30a communicating with the first recess 50a are formed by completely removing the light absorbing layer 30, as well as the buffer layer 30, but the second step is not limited thereto. For example, only a portion of the light absorbing layer 30 may be removed when removing the light absorbing layer 30.

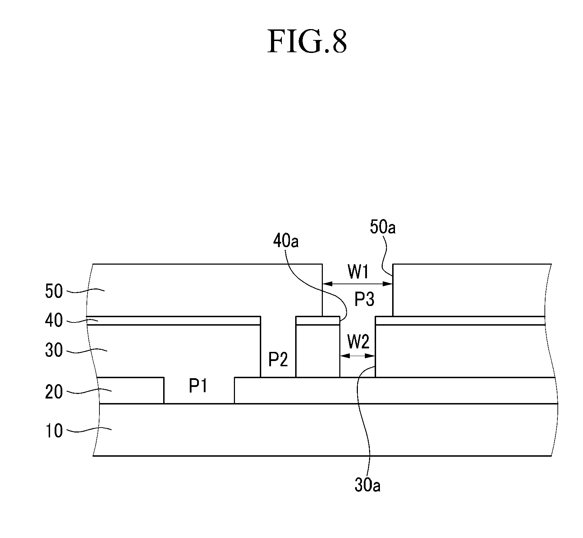

In one embodiment, in the third patterning, a third isolation region P3 is formed adjacent to the second isolation region P2 formed by the first and second recesses 50a, 40a, and 30a, and thus a structure in which a plurality of unit cells are electrically connected in series is provided on the substrate 10 (see e.g., FIG. 8).

In one embodiment, a cross-section of the third isolation region P3 has step-shaped patterns in a direction perpendicular to the substrate 10. In one embodiment, the step-shaped patterns oppose one another. In one embodiment, the step-shaped patterns form a bisymmetric step-shaped pattern (e.g. the step-shaped patterns are mirror images of one other). In one embodiment, the step-shaped patterns are opposite step-shaped patterns.

In some embodiments, when the third isolation region P3 has the step-shaped pattern as described above, physical power (e.g., mechanical energy) used when forming the recess 30a at the light absorbing layer 30 does not substantially influence the second electrode 50, thereby preventing or reducing any undesired removal of the second electrode 50.

Accordingly, the third isolation region P3 may be formed without (or substantially without) defects, and when the third isolation region P3 does not influence a peripheral region of the pattern as described above, the third isolation region P3 may be disposed adjacent to the other isolation regions P1 and P2. Accordingly, in some embodiments, an area occupied by the isolation regions is minimized (or decreased), while a light conversion portion is maximized (or increased), on one unit cell, thereby maximizing (or increasing) light conversion efficiency per unit area.

According to one embodiment, in order to modulate the solar cell, undesired damage to the second electrode is prevented or reduced when the isolation region is formed in the light absorbing layer and the second electrode.

According to some embodiments, in the manufactured solar cell, it is possible to form the isolation region without (or substantially without) defects, and to minimize (or decrease) a space occupied by the isolation region on one unit cell, thereby improving light conversion efficiency per unit area.

While this disclosure has been described in connection with certain embodiments, it is to be understood that the invention is not limited to the disclosed embodiments, but, on the contrary, is intended to cover various modifications and equivalent arrangements included within the scope of the appended claims, and equivalents thereof.

## Claims

1. A solar cell, comprising:
a substrate; and
a plurality of electrically connected unit cells on the substrate,
wherein:
a unit cell of the unit cells comprises a first electrode, a light absorbing layer, and a second electrode, sequentially stacked,
adjacent unit cells of the unit cells are separated by an isolation region,
the isolation region is between the light absorbing layers of the adjacent unit cells and between the second electrodes of the adjacent unit cells,
a cross-section of the isolation region has step-shaped patterns in a direction perpendicular to the substrate, and
the step-shaped patterns oppose one another.

2. The solar cell of claim 1, wherein the isolation region has a recess structure.

3. The solar cell of claim 2, wherein, in the recess structure, a width of a recess of the light absorbing layer is smaller than a width of a recess of the second electrode.

4. The solar cell of claim 3, wherein the width of the recess of the second electrode is 30 µm to 70 µm.

5. The solar cell of any of claims 1 to 4, wherein the step-shaped patterns form a bisymmetric step-shaped pattern.

6. The solar cell of any of claims 1 to 5, wherein the step-shaped patterns are opposite step-shaped patterns in the direction perpendicular to the substrate.

7. The solar cell of any of claims 1 to 6, wherein the second electrode is conductive and transparent, optionally wherein the second electrode includes one selected from the group consisting of BZO, ZnO, In₂O₃, and ITO.

8. The solar cell of any of claims 1 to 7, wherein the unit cell of the unit cells further comprises a buffer layer between the light absorbing layer and the second electrode, and wherein the isolation region is between the buffer layers of the adjacent unit cells.

9. A method of manufacturing a solar cell, the method comprising:
sequentially stacking a first electrode, a light absorbing layer, and a second electrode on a substrate; and
forming an isolation region in the light absorbing layer and the second electrode,
wherein the forming of the isolation region includes heat-forming a portion of the isolation region followed by mechanical-forming another portion of the isolation region.

10. The method of claim 9, wherein the heat-forming is performed by a laser, optionally wherein the laser has a wavelength of 266 nm to 1,064 nm, and a pulse width of 0.001 ns to 100 ns.

11. The method of claim 9 or claim 10, wherein the mechanical-forming is performed by a needle.

12. The method of any of claims 9 to 11, wherein in the heat-forming, the second electrode is completely removed or partially removed from the light absorbing layer and/or wherein in the mechanical-forming, the light absorbing layer is completely removed or partially removed from the substrate.

13. The method of claim 10, wherein a cross-section of the isolation region has step-shaped patterns in a direction perpendicular to the substrate, and wherein the step-shaped patterns oppose one another, optionally forming a bisymmetric step-shaped pattern.

14. The method of any of claims 9 to 13, wherein a cross-section of the isolation region has step-shaped patterns in a direction perpendicular to the substrate, and wherein the step-shaped patterns are opposite step-shaped patterns in the direction perpendicular to the substrate.

15. The method of any of claims 9 to 14, further comprising stacking a buffer layer between the light absorbing layer and the second electrode, optionally wherein the forming of the isolation region in the light absorbing layer and the second electrode, includes forming the isolation region in the buffer layer.
